# EUROPEAN PATENT SPECIFICATION

(11) **EP 1 364 420 B1**
(45) Date of publication and mention of the grant of the patent: **10.10.2012**
(21) Application number: 02702497.5
(22) Date of filing: 27.02.2002
(51) Int. Cl.: H01L 51/40

(54) **FORMULATION FOR DEPOSITING A MATERIAL ON A SUBSTRATE USING INK JET PRINTING**
FORMULIERUNG FÜR DIE ABSCHEIDUNG VON MATERIAL AUF EINEM SUBSTRAT MITTELS TINTENSTRAHLDRUCK
PREPARATION ET TECHNIQUE DE DEPOT D'UN MATERIAU SUR UN SUBSTRAT

(30) Priority: 27.02.2001 CN 01104585; 28.02.2001 GB 0104875; 28.03.2001 GB 0107740
(43) Date of publication of application: 26.11.2003
(73) Proprietor: Cambridge Display Technology Limited, Cambridgeshire, CB3 6DW (GB)
(72) Inventor: LYON, Peter John, Cambridge CB3 0TX (GB); CARTER, Julian C., Cambridge CB3 0TX (GB); BRIGHT, C.J., Cambridge CB3 0TX (GB); CACHEIRO, Martin, Cambridge CB3 0TX (GB)
(74) Representative: Gilani, Anwar
(86) International application number: PCT/GB2002/000845
(87) International publication number: WO 2002/069119

(56) References cited:
- WO-A-00/59267
- WO-A-99/12398
- WO-A-99/29789
- WO-A-99/54385
- US-A- 5 091 004

## Description

The present invention relates to a formulation for depositing a material on a substrate, to a method of depositing a material on a substrate particularly by an ink-jet deposition technique, and to a method of producing a light-emitting device by such a deposition method.

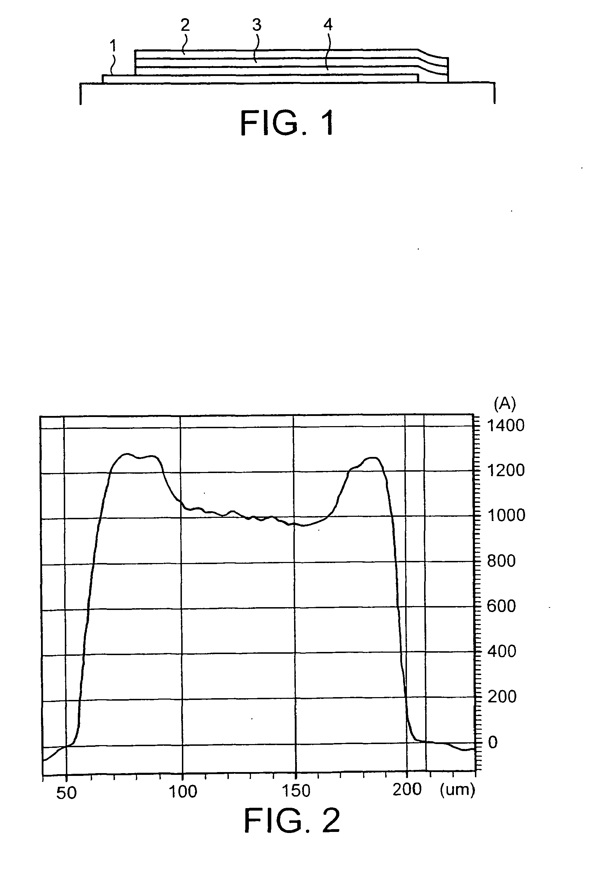

As shown schematically in Figure 1, a light-emitting device typically comprises a layer of an electroluminescent polymer 3 sandwiched between a cathode 2 and an anode 1 such that charge carriers can move between the electrodes and the layer of electroluminescent polymer. It is typically produced by depositing a layer of electroluminescent polymer 3 on a glass substrate 5 coated with an anode layer 1 such as a layer of indium-tin oxide (ITO) and depositing a cathode layer 2 such as a calcium layer over the layer of electroluminescent polymer 3. The device may comprise further layers, such as a hole transport layer 4 (such as a layer of doped polyethylene dioxythiophene as described in EP0686662) provided between the anode 1 and the electroluminescent polymer layer 3 and an electron transport layer provided between the cathode and the electroluminescent layer (not provided in the device shown in Figure 1).

An ink-jet technique may be used for depositing the layer of electroluminescent polymer. Such a technique is described in EP0880303A1, whose content is incorporated herein by reference. This technique basically involves the controlled deposition of drops of a solution of the electroluminescent polymer through a nozzle followed by evaporation of the solvents. This technique is particularly suited to the deposition of patterned layers of the electroluminescent polymer. For example, in some applications, it may be required to have a layer of electroluminescent polymer comprising an ordered array of pixels, wherein each pixel is produced by the deposition of a single drop of solution of the electroluminescent polymer. It is desirable in such cases that the polymer is distributed uniformly in the spot remaining after evaporation of the solvent.

Solutions of the electroluminescent polymer in solvents such as isodurene have conventionally been used in this technique. However, there has been noticed the problem with conventional solvents that after a drop of the deposited solution has dried most of the electroluminescent polymer is deposited as a ring around the edge of the remaining spot leaving only a very thin film of the polymer at the centre of the spot. This can result in relatively poor device efficiency.

It is an aim of the present invention to provide a formulation with which a film of the desired thickness profile can be deposited on a substrate according to a technique involving controlled drop deposition.

According to a first aspect of the present invention, there is provided a formulation for depositing a material on a substrate as defined in claim 1..

References to the solubility of each solvent component with respect to the material are references to the solubility of the material in each solvent component.

Ink-jet techniques typically require formulations having a viscosity of up to about 20cps. A typical viscosity for an ink-jet formulation is about 10cps.

The first solvent component comprises one or more solvents that have a relatively high boiling point and exhibit a relatively low solubility with respect to the material to be deposited (in relation to the second solvent component), and the second solvent component may likewise comprise one or more solvents that have a relatively low boiling point and exhibit a relatively high solubility with respect to the material to be deposited (in relation to the first solvent component).

In one embodiment, the second solvent component has a boiling point in the range of 100° to 200°C and the first solvent component has a boiling point in the range of 130° to 300°C. The difference in boiling point between the first and second solvent components is preferably in the range of 30° to 250°C, further preferably in the range of 70° to 150°C. The solubility of the material to be deposited in the first solvent component is preferably up to 0.5% weight per volume, further preferably in the range of 0.03 to 0.3% weight per volume, and the solubility of the material to be deposited in the second solvent is preferably greater than 0.5% weight per volume, further preferably greater than 1.5% weight per volume.

The proportion of the first solvent component should preferably be selected such that upon removal of the second solvent component the remaining solution of the material in the first solvent component would be substantially at or above saturation. In one embodiment, the proportion of the first solvent component is in the range of 10 to 60 volume percent, further preferably 20 to 50 volume percent.

In one embodiment, the proportion of the second solvent component is in the range of 40 to 90 volume percent, preferably 50 to 80 volume percent.

According to another aspect of the invention, there is provided a method of depositing a material on a substrate comprising depositing one or more drops of a solution of the material onto the substrate through a nozzle according to an ink-jet technique and drying each deposited drop, wherein the solution of the material comprises a formulation as described above.

The solvent system is selected such that the material begins to precipitate at a relatively early stage in the drying of the drop, i.e. such that precipitation occurs whilst a substantial amount of solvent remains unevaporated.

The solvent system is selected such that the variation in thickness of the dried drop of material on the substrate is less than 80% of the maximum thickness, preferably less than 50%, and further preferably less than 30%. It is most preferred that the thickness variation is less than 15%.

In one embodiment, the solvent system is selected such that in a formulation having 0.5% w/v of the material to be deposited, the dried drop has a thickness at its centre (i.e. the region enclosed by the ring of increased thickness, if present) of 60 to 140nm, preferably about 70nm to 100nm, which is desirable for EL efficiency and lifetime of an organic light-emitting device.

The material for deposition on the substrate comprises one or more semiconducting conjugated polymers such as a charge transport polymer or a light-emissive polymer, or a blend of the two.

The present invention can be used, in a method of producing a light-emitting device comprising a layer of an electroluminescent material sandwiched between two electrodes such that charge carriers can move between the electrodes and the layer of electroluminescent material, wherein the layer of electroluminescent material is produced by a method as described above.

The present invention, reduces or avoids a ring deposition effect.

Embodiments of the present invention shall be described hereunder, by way of example only, with reference to the accompanying drawings in which:-
Figure 1 is a schematic view of a light-emissive device;
Figures 2 and 3 are graphs showing the thickness profile for a spot obtained by an ink-jet technique using a formulation according to embodiments of the present invention;
Figure 4 is a graph showing the thickness profile for a spot of an electroluminescent polymer deposited using a solvent consisting entirely of 1,2-dimethylbenzene;
Figure 5 is a graph showing the thickness profile for a spot obtained by an ink-jet technique using a formulation according to another embodiment of the present invention; and

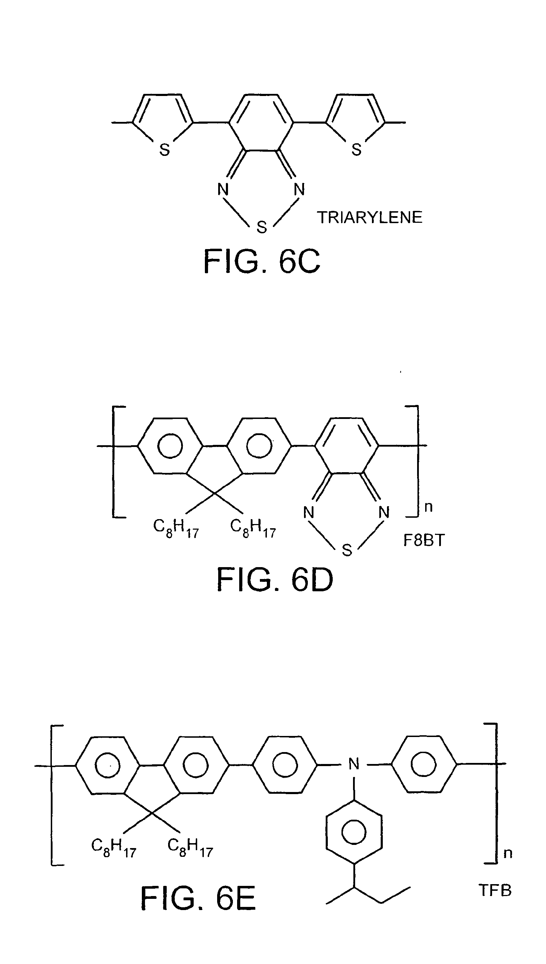

Figure 6 illustrates some recurring units and polymers.

### Example 1

A solvent blend was prepared from 60 vol.% 1,2-dimethylbenzene (b.p.: 144.4°C) and 40 vol.% α-tetralone (b.p.: 255°C). A 0.5% w/v solution of an alternating polymer of 9,9-dioctylfluorene units and benzothiadiazole units (F8BT) having a peak molecular weight of about 266,000 was prepared using this solvent blend. Drops of this solution were deposited by an ink-jet method on the surface of a polyimide substrate that had been modified to lower its surface energy. The drops were allowed to dry at room temperature and humidity (20°C ± 1.0°C and 30-40% R.H.), and Dektak measurements of the profile of the dried drops were taken. The results of the measurements are shown in Figure 2.

### Example 2

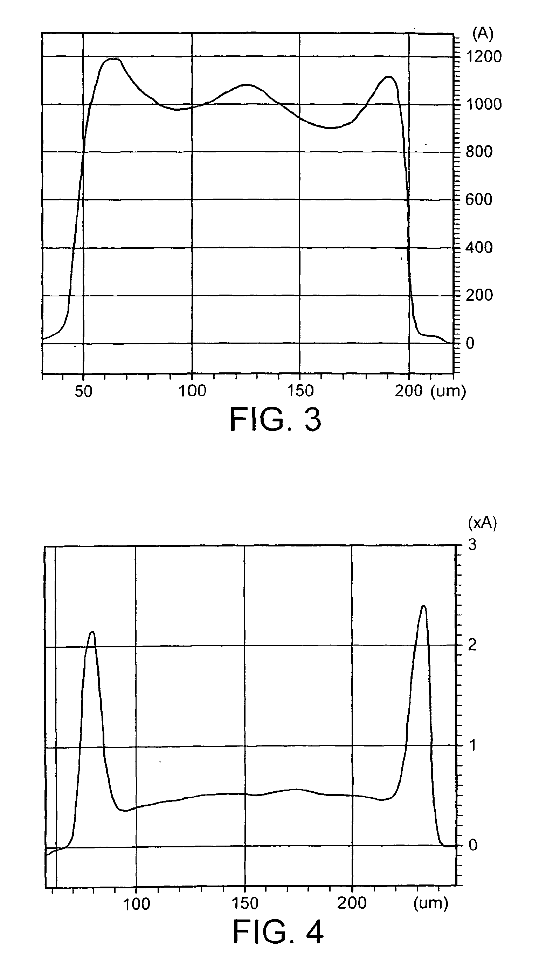

A solvent blend was prepared from 60 vol.% 1,2-dimethylbenzene and 40 vol.% cyclohexylbenzene. Drops of a 0.5% w/v solution of the same F8BT polymer as Example 1 were deposited on a surface-modified polyimide substrate by an ink-jet method. Dektak measurements of the profile of the dried drops were taken. The results of the measurements are shown in Figure 3.

### Comparative Example

Drops of a 0.5% w/v solution of the same F8BT polymer as Examples 1 and 2 in 1,2-dimethylbenzene were deposited on a surface-modified polyimide substrate by an ink-jet method. Dektak measurements of the profile of the dried drops were taken. The results of the measurements are shown in Figure 4.

As can be seen from a comparison of Figures 2, 3 and 4, the use of the formulations according to the present invention produced dried drops that were significantly improved in terms of uniformity of thickness compared to the comparative example. It is thought that the improved thickness uniformity is a result of the following mechanism. During drying of the drop, the volatile low boiling point solvent evaporates quickly leaving behind a saturated solution in the high boiling point solvent; this in turn causes the polymer to be precipitated rapidly preventing radial flow within the drop and thus creating a relatively uniform distribution of the polymer in the drop.

Furthermore, the improved uniformity of thickness results in an increased thickness at the centre of the drop for the same concentration of material in the formulation. Being able to control the thickness at the centre of the drop is considered to be an important factor in improving the efficiency of a light-emitting device produced by an ink-jet technique. The present invention thus allows an increase in centre thickness without increasing the concentration in the formulation of the material to be deposited. This can have advantages in producing a device having pixels of the desired size at the desired resolution.

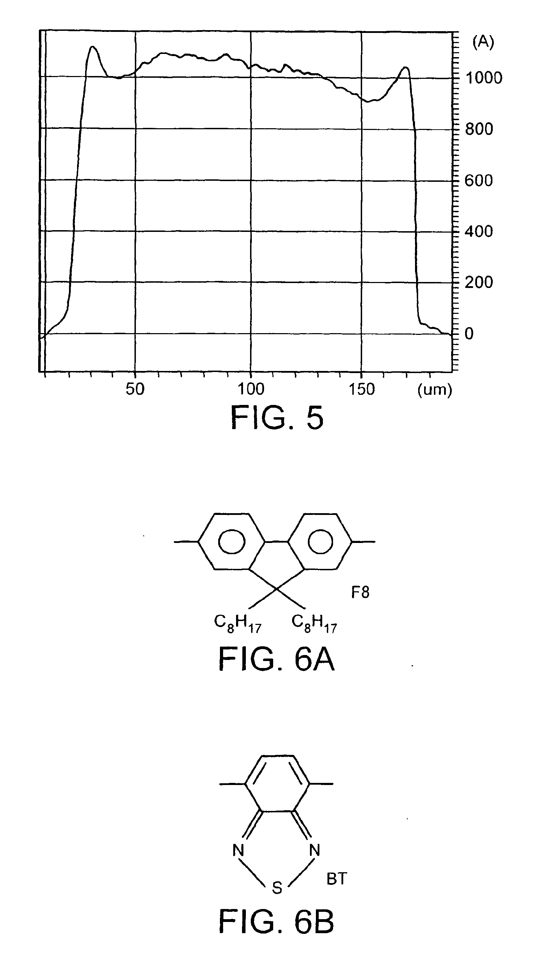

Good results have also been achieved using a solvent blend consisting of 40vol.% mixed isomers of xylene (b.p.:138°C); 40 vol.% 1,2,4-trimethylbenzene (b.p.:168°C) and 20 vol.% 3-isopropylbiphenyl (b.p.:295°C). Figure 5 shows a Dektak measurement profile of a dried drop deposited by an ink-jet technique using a 0.5% w/v solution of a polymer blend in this three component solvent system. The polymer blend is relatively highly soluble in the first two, low boiling point solvents relative to the third high boiling point solvent.

## Claims

1. A formulation for depositing a material on a substrate according to an ink-jet technique, the formulation comprising the material to be deposited on the substrate dissolved in a solvent system comprising first and second solvent components, the first solvent component having a relatively high boiling point and exhibiting a relatively low solubility with respect to the material to be deposited compared to the second solvent component, and the second solvent component having a relatively low boiling point and exhibiting a relatively high solubility with respect to the material to be deposited compared to the first solvent component, **characterised in that** the material comprises one or more semiconducting conjugated polymer(s).

2. A formulation according to claim 1 wherein the second solvent component has a boiling point in the range of 100° to 200° C.

3. A formulation according to claim 1 or claim 2 wherein the first solvent component has a boiling point in the range of 130° to 300° C.

4. A formulation according to claim 1 wherein the difference in boiling point between the first and second solvent components is in the range of 30 to 250°C.

5. A formulation according to claim 4 wherein the difference in boiling point between the first and second solvent components is in the range of 70° to 150° C.

6. A formulation according to any preceding claim wherein the solubility of the material to be deposited in the first solvent component is up to 0.5% weight per volume.

7. A formulation according to claim 6 wherein the solubility of the material to be deposited in the first solvent component is in the range of 0.03 to 0.3% weight per volume.

8. A formulation according to any preceding claim wherein the solubility of the material to be deposited in the second solvent component is greater than 0.5% weight per volume.

9. A formulation according to claim 8 wherein the solubility of the material to be deposited in the second solvent component is greater than 1.5% weight per volume.

10. A formulation according to any preceding claim wherein the amount of material in the formulation and the proportion of the first solvent component are selected such that upon removal of the second solvent component the remaining solution of the material in the first solvent component would be at or above saturation.

11. A formulation according to claim 1 wherein the first solvent component comprise α-tetralone and the second solvent component comprises 1,2-dimethylbenzene.

12. A formulation according to claim 1 wherein the first solvent component comprises cyclohexylbenzene and the second solvent component comprises 1,2-dimethylbenzene.

13. A formulation according to claim 1 wherein the first solvent component comprises xylene and 1,2,4-trimethylbenzene and the second solvent component comprises isopropylbiphenyl.

14. A method of depositing a semiconducting conjugated polymer material on a substrate comprising depositing one or more drops of a solution of the said material onto the substrate through a nozzle according to an ink-jet technique and drying the drops, wherein the solution of the material comprises a formulation according to any preceding claim.

## Patentansprüche

1. Formulierung zum Abscheiden eines Materials auf einem Substrat gemäß einer Tintenstrahltechnik, wobei die Formulierung das auf dem Substrat abzuscheidende Material in einem Lösungsmittelsystem, das eine erste und eine zweite Lösungsmittelkomponente umfasst, gelöst umfasst, wobei die erste Lösungsmittelkomponente einen relativ hohen Siedepunkt und eine relativ geringe Löslichkeit bezüglich des abzuscheidenden Materials im Vergleich zu der zweiten Lösungsmittelkomponente aufweist und die zweite Lösungsmittelkomponente einen relativ niedrigen Siedepunkt und eine relativ hohe Löslichkeit bezüglich des abzuscheidenden Materials im Vergleich zu der ersten Lösungsmittelkomponente aufweist, **dadurch gekennzeichnet, dass** das Material ein oder mehrere halbleitende konjugierte Polymere umfasst.

2. Formulierung nach Anspruch 1, wobei die zweite Lösungsmittelkomponente einen Siedepunkt im Bereich von 100 bis 200°C aufweist.

3. Formulierung nach Anspruch 1 oder Anspruch 2, wobei die erste Lösungsmittelkomponente einen Siedepunkt im Bereich von 130 bis 300°C aufweist.

4. Formulierung nach Anspruch 1, wobei die Siedepunktsdifferenz zwischen der ersten und der zweiten Lösungsmittelkomponente im Bereich von 30 bis 250°C liegt.

5. Formulierung nach Anspruch 4, wobei die Siedepunktsdifferenz zwischen der ersten und der zweiten Lösungsmittelkomponente im Bereich von 70 bis 150°C liegt.

6. Formulierung nach einem der vorhergehenden Ansprüche, wobei die Löslichkeit des abzuscheidenden Materials in der ersten Lösungsmittelkomponente bis zu 0,5 Gew.-% pro Volumen beträgt.

7. Formulierung nach Anspruch 6, wobei die Löslichkeit des abzuscheidenden Materials in der ersten Lösungsmittelkomponente im Bereich von 0,03 bis 0,3 Gew.-% pro Volumen liegt.

8. Formulierung nach einem der vorhergehenden Ansprüche, wobei die Löslichkeit des abzuscheidenden Materials in der zweiten Lösungsmittelkomponente mehr als 0,5 Ges.-% pro Volumen beträgt.

9. Formulierung nach Anspruch 8, wobei die Löslichkeit des abzuscheidenden Materials in der zweiten Lösungsmittelkomponente mehr als 1,5 Gew.-% pro Volumen beträgt.

10. Formulierung nach einem der vorhergehenden Ansprüche, wobei die Materialmenge in der Formulierung und der Anteil der ersten Lösungsmittelkomponente so gewählt sind, dass sich nach Entfernung der zweiten Lösungsmittelkomponente die verbliebene Lösung des Materials in der ersten Lösungsmittelkomponente bei oder oberhalb der Sättigung befindet.

11. Formulierung nach Anspruch 1, wobei die erste Lösungsmittelkomponente α-Tetralon umfasst und die zweite Lösungsmittelkomponente 2-Dimethylbenzol umfasst.

12. Formulierung nach Anspruch 1, wobei die erste Lösungsmittelkomponente Cyclohexylbenzol umfasst und die zweite Lösungsmittelkomponente 1,2-Dimethylbenzol umfasst.

13. Formulierung nach Anspruch 1, wobei die erste Lösungsmittelkomponente Xylol und 1,2,4-Trimethylbenzol umfasst und die zweite Lösungsmittelkomponente Isopropylbiphenyl umfasst.

14. Verfahren zum Abscheiden eines halbleitenden konjugierten Polymermaterials auf einem Substrat, bei dem man einen oder mehrere Tropfen einer Lösung des Materials durch eine Düse gemäß einer Tintenstrahltechnik auf dem Substrat abscheidet und die Tropfen trocknet, wobei die Lösung des Materials eine Formulierung nach einem der vorhergehenden Ansprüche umfasst.

## Revendications

1. Formulation pour déposer un matériau sur un substrat selon une technique de jet d'encre, la formulation comprenant le matériau à déposer sur le substrat dissous dans un système de solvant comprenant un premier et un deuxième composant de solvant, le premier composant de solvant ayant un point d'ébullition relativement élevé et présentant une solubilité relativement faible vis-à-vis du matériau à déposer en comparaison du deuxième composant de solvant, et le deuxième composant de solvant ayant un point d'ébullition relativement bas et présentant une solubilité relativement élevée vis-à-vis du matériau à déposer en comparaison du premier composant de solvant, **caractérisée en ce que** le matériau comprend un ou plusieurs polymères semi-conducteurs conjugués.

2. Formulation selon la revendication 1 dans laquelle le deuxième composant de solvant a un point d'ébullition dans la gamme de 100 à 200 °C.

3. Formulation selon la revendication 1 ou la revendication 2 dans laquelle le premier composant de solvant a un point d'ébullition dans la gamme de 130 à 300 °C.

4. Formulation selon la revendication 1 dans laquelle la différence de point d'ébullition entre le premier et le deuxième composant de solvant se situe dans la gamme de 30 à 250 °C.

5. Formulation selon la revendication 4 dans laquelle la différence de point d'ébullition entre le premier et le deuxième composant de solvant se situe dans la gamme de 70 à 150 °C.

6. Formulation selon l'une quelconque des revendications précédentes dans laquelle la solubilité du matériau à déposer dans le premier composant de solvant va jusqu'à 0,5 % en poids par volume.

7. Formulation selon la revendication 6 dans laquelle la solubilité du matériau à déposer dans le premier composant de solvant se situe dans la gamme de 0,03 à 0,3 % en poids par volume.

8. Formulation selon l'une quelconque des revendications précédentes dans laquelle la solubilité du matériau à déposer dans le deuxième composant de solvant est supérieure à 0,5 % en poids par volume.

9. Formulation selon la revendication 8 dans laquelle la solubilité du matériau à déposer dans le deuxième composant de solvant est supérieure à 1,5 % en poids par volume.

10. Formulation selon l'une quelconque des revendications précédentes dans laquelle la quantité de matériau dans la formulation et la proportion du premier composant de solvant sont choisies de telle sorte que lors du retrait du deuxième composant de solvant la solution restante du matériau dans le premier composant de solvant serait à ou au-dessus de la saturation.

11. Formulation selon la revendication 1 dans laquelle le premier composant de solvant comprend de l'a-tétralone et le deuxième composant de solvant comprend du 1,2-diméthylbenzène.

12. Formulation selon la revendication 1 dans laquelle le premier composant de solvant comprend du cyclohexyl-benzène et le deuxième composant de solvant comprend du 1,2-diméthylbenzéne.

13. Formulation selon la revendication 1 dans laquelle le premier composant de solvant comprend du xylène et du 1,2,4-triméthylbenzène et le deuxième composant de solvant comprend de l'isopropylbiphényle.

14. Procédé de dépôt d'un matériau polymère semiconducteur conjugué sur un substrat comprenant le dépôt d'une ou plusieurs gouttes d'une solution dudit matériau sur le substrat par une buse selon une technique de jet d'encre et le séchage des gouttes, dans lequel la solution du matériau comprend une formulation selon l'une quelconque des revendications précédentes.
